(19) **Europäisches Patentamt**

**European Patent Office**

**Office européen des brevets**

(11) **EP 0 989 669 B1**

(12) **FASCICULE DE BREVET EUROPEEN**

(45) Date de publication et mention
de la délivrance du brevet:
**12.11.2003 Bulletin 2003/46**

(51) Int Cl.⁷: **H03B 27/00, H03B 28/00**

(21) Numéro de dépôt: **99402346.3**

(22) Date de dépôt: **24.09.1999**

(54) **Générateur numérique de fréquences**

Digitaler Frequenzgenerator

Digital frequency generator

(84) Etats contractants désignés:
**AT BE CH CY DE DK ES FI FR GB GR IE IT LI LU
MC NL PT SE**

(30) Priorité: **25.09.1998 FR 9812024**

(43) Date de publication de la demande:
**29.03.2000 Bulletin 2000/13**

(73) Titulaire: **Thales
75008 Paris (FR)**

(72) Inventeurs:
• **Julie, Jean-Jacques,
Thomson-CSF Prop. Int. Dpt Br
94117 Arcueil Cedex (FR)**
• **Cerutti, Françoise,
Thomson-CSF P.I. Dpt. Brevets
94117 Arcueil Cedex (FR)**

(74) Mandataire: **Albert, Claude et al
Thomson-CSF Propriété Intellectuelle,
13, Avenue du Président Salvador Allende
94117 Arcueil Cédex (FR)**

(56) Documents cités:
**US-A- 3 679 881        US-A- 5 198 779**

• **PATENT ABSTRACTS OF JAPAN vol. 014, no.
051 (E-0881), 30 janvier 1990 (1990-01-30) -& JP
01 278104 A (OKI ELECTRIC IND CO LTD), 8
novembre 1989 (1989-11-08)**
• **AL-IBRAHIM M M ET AL: "DIGITAL SINUSOIDAL
OSCILLATOR WITH LOW AND UNIFORM
FREQUENCY SPACING" IEE PROCEEDINGS:
CIRCUITS DEVICES AND SYSTEMS, vol. 144, no.
3, 1 juin 1997 (1997-06-01), pages 185-189,
XP000731522**

**Description**

L'invention concerne le domaine des générateurs numériques de fréquences. Lors des changements de fréquences dans un générateur numérique de fréquences, se pose le problème de la maîtrise de la phase de l'onde générée par le générateur de fréquences.

Une solution de l'art antérieur consiste à utiliser un dispositif à table d'accumulation de phase. Mais ce dispositif ne permet de maîtriser la phase qu'imparfaitement et aux dépens du rapport signal à bruit. De plus, ce dispositif est complexe.

L'invention propose un générateur numérique de fréquences basé sur l'utilisation d'un réseau récursif du deuxième ordre. Ce générateur est simple et autorise une parfaite maîtrise de la phase.

Selon l'invention, il est prévu un générateur numérique de fréquences F ayant une horloge avec une période d'échantillonnage $T_{ech}$ et comportant un premier réseau récursif du deuxième ordre, le premier réseau comportant

- un premier groupe de deux registres à décalage en série pouvant chacun stocker un échantillon de signal et comportant chacun une première entrée, une deuxième entrée de chargement, une sortie ;
- des premiers moyens de multiplication comportant une entrée et une sortie et ayant un coefficient de multiplication valant $2\cos(\theta)$ avec $\theta$ valant $2\pi FT_{ech}$ ;
- des premiers moyens de soustraction comportant une entrée directe, une entrée inverseuse, une sortie ;

la sortie du premier registre étant reliée à la première entrée du deuxième registre, la première entrée du premier registre étant reliée à la sortie des premiers moyens de soustraction, la sortie du deuxième registre étant reliée à l'entrée inverseuse des premiers moyens de soustraction, l'entrée des premiers moyens de multiplication étant reliée à la sortie du premier registre, la sortie des premiers moyens de multiplication étant reliée à l'entrée directe des premiers moyens de soustraction, les deuxièmes entrées de chargement des premier et deuxième registres étant reliées à l'extérieur ;

à chaque coup d'horloge, l'échantillon de signal stocké dans chaque registre étant rendu disponible sur sa sortie, les premiers moyens de multiplication effectuant une opération de multiplication, les premiers moyens de soustraction effectuant une opération de soustraction, l'échantillon de signal reçu à l'entrée de chaque registre étant stocké dans ledit registre ;

caractérisé en ce que le générateur comporte des moyens de commande des registres remplaçant, lors d'un changement de fréquence porteuse F ou bien lors d'un changement de période d'échantillonnage $T_{ech}$, l'échantillon de signal stocké dans chaque registre par un échantillon de signal chargé à partir de l'extérieur au niveau de sa deuxième entrée de chargement et déterminé de manière à maîtriser la phase de la fréquence F.

Un générateur numérique de fréquences selon le préambule de la revendication 1 est décrit dans la demande de brevet japonaise JP 1 278 104.

L'invention sera mieux comprise et d'autres particularités et avantages apparaîtront à l'aide de la description ci-après et des dessins joints, donnés à titre d'exemples, où :

- la figure 1 représente schématiquement un premier mode de réalisation d'un générateur numérique selon l'invention ;
- la figure 2 représente schématiquement un deuxième mode de réalisation d'un générateur numérique selon l'invention ;
- la figure 3 représente schématiquement un troisième mode de réalisation d'un générateur numérique selon l'invention.

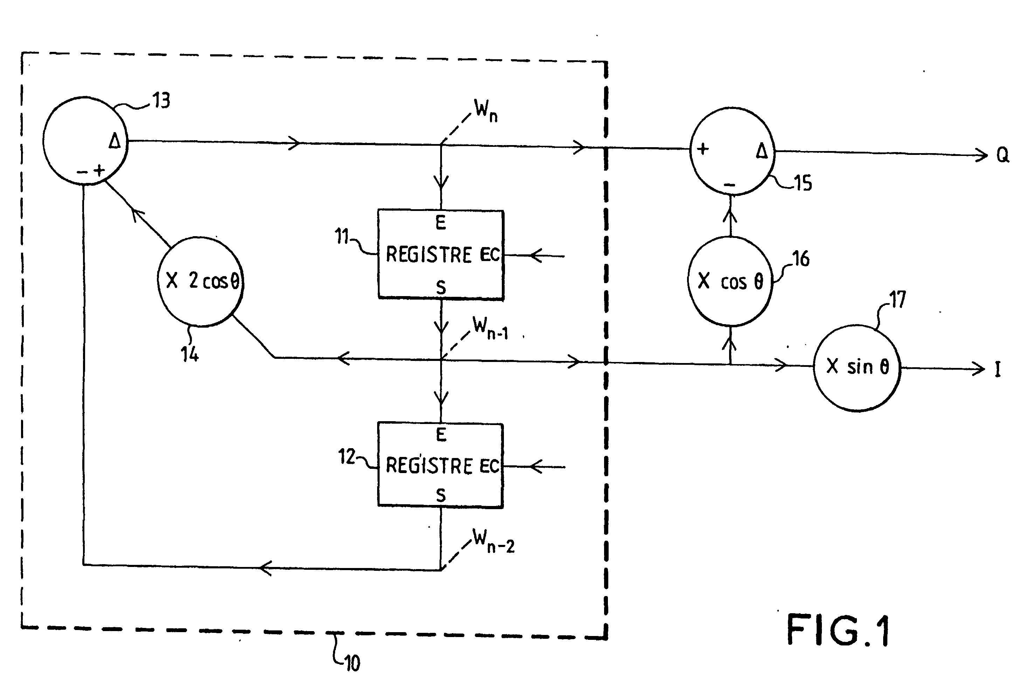

La figure 1 représente schématiquement un premier mode de réalisation préférentiel d'un générateur numérique de fréquences F utilisant un réseau 10 récursif du deuxième ordre. Le réseau 10 comporte un premier registre 11 à décalage, un deuxième registre 12 à décalage, des premiers moyens de soustraction 13, des premiers moyens de multiplication 14.

Chaque registre peut stocker un échantillon de signal. Chaque registre a une première entrée E, une deuxième entrée EC de chargement, une sortie S. Le générateur a une horloge, non représentée sur la figure 1, de période d'échantillonnage $T_{ech}$, commandant chacun des registres qui effectue à chaque coup d'horloge par défaut les opérations suivantes : le échantillon de signal stocké dans le registre est rendu disponible sur la sortie S du registre ; l'échantillon de signal reçu à la première entrée E du registre est stocké dans le registre en question. Si l'échantillon de signal reçu à la première entrée E du registre est appelé $W_n$, l'échantillon de signal disponible sur la sortie S du registre sera appelé $W_{n-1}$, puisqu'il est égal à celui reçu un coup d'horloge auparavant sur la première entrée E du registre. Des moyens de commande du registre, non représentés ici, permettent de remplacer l'échantillon de signal stocké dans le registre par un échantillon de signal chargé à partir de l'extérieur au niveau de la deuxième entrée EC de chargement du registre. Il peut y avoir différentes façons pratiques de réaliser cela : par exemple le échantillon de signal chargé au niveau de la deuxième entrée EC de chargement peut être stocké dans le registre entre deux coups d'horloge, ou bien l'échantillon de signal chargé au niveau de la deuxième entrée EC de chargement peut être directement rendu disponible sur la sortie S à la place de l'échantillon de signal stocké dans le registre : il s'agit à un moment ou à un autre de remplacer l'échantillon de signal traversant le registre de sa première entrée E vers sa sortie S par un échantillon de signal chargé sur sa deuxième entrée EC de chargement.

Les premiers moyens 13 de soustraction comportent une entrée directe +, une entrée inverseuse -, et une sortie $\Delta$ faisant la différence entre l'échantillon de signal à l'entrée directe + et l'échantillon de signal à l'entrée inverseuse - des premiers moyens 13 de soustraction.

Les premiers moyens 14 de multiplication comportent une entrée et une sortie. Les premiers moyens 14 de multiplication effectuent une opération de multiplication, l'échantillon de signal disponible à leur sortie valant l'échantillon de signal à leur entrée multiplié par un coefficient de multiplication. Avec $\theta$ valant $2\pi FT_{ech}$, le coefficient de multiplication vaut $2\cos(\theta)$ pour les premiers moyens 14 de multiplication. Ce coefficient de multiplication dépend donc de la ou des fréquences F à générer.

Les registres 11 et 12 sont en série, c'est-à-dire que la sortie S du premier registre 11 est reliée à l'entrée E du deuxième registre 12. Ici et dans toute la suite du brevet, « relié » signifie soit directement relié comme sur la figure 1, soit relié par l'intermédiaire d'un autre élément, qui serait situé par exemple ici entre la sortie S du premier registre 11 et la première entrée E du deuxième registre 12. Les flèches donnent le sens de circulation des échantillons de signal. Sauf mention contraire, dans tout le texte, les entrées et les sorties sont définies par rapport au sens de circulation des échantillons de signal, c'est-à-dire que les échantillons de signal arrivent sur une entrée d'un élément et repartent sur une sortie de l'élément. A un instant donné, si on appelle $W_n$ l'échantillon de signal reçu sur la première entrée du premier registre 11, on appellera $W_{n-1}$ l'échantillon de signal disponible sur la sortie S du premier registre 11 alors identique à l'échantillon de signal reçu sur la première entrée E du deuxième registre 12, et on appellera $W_{n-2}$ l'échantillon de signal disponible sur la sortie S du deuxième registre 12 ; la position de ces échantillons de signal sont indiqués par des traits pointillés sur la figure. Les deuxièmes entrées EC de chargement des registres sont reliées à des moyens extérieurs, non représentés ici, lesquels chargent sur les deuxièmes entrées EC de chargement des registres des échantillons de signal appelés échantillons de signal chargés.

L'entrée inverseuse - des premiers moyens 13 de soustraction est reliée à la sortie S du deuxième registre 12, tandis que la première entrée E du premier registre 11 est reliée à la sortie $\Delta$ des premiers moyens 13 de soustraction. L'entrée directe + des premiers moyens 13 de soustraction est reliée à la sortie des premiers moyens 14 de multiplication dont l'entrée est reliée à la sortie S du premier registre 11.

Ainsi, à chaque coup d'horloge, les échantillons de signal stockés dans les registres, ou le cas échéant les échantillons de signal chargés au niveau des entrées EC de chargement, sont rendus disponibles sur les sorties S des registres 11 et 12, et valent respectivement $W_{n-1}$ et $W_{n-2}$ ; ces échantillons de signal traversent les premiers moyens 14 de multiplication et les premiers moyens 13 de soustraction pour que l'échantillon de signal reçu sur la première entrée E du premier registre 11 vaille $W_n = 2\cos(\theta)W_{n-1} - W_{n-2}$. Cet échantillon de signal $W_n$ reçu sur la première entrée E du premier registre 11 est alors stocké dans le premier registre 11, tandis qu'un échantillon de signal valant $W_{n-1}$ est stocké dans le deuxième registre 12. A partir du coup d'horloge, le temps qui s'écoule entre la mise à disposition sur la sortie S du premier registre 11 par exemple de l'échantillon de signal valant $W_{n-1}$ et le stockage dans le premier registre 11 de l'échantillon de signal valant $W_n$ dépend de la rapidité des différents éléments : premier registre 11, premiers moyens 13 de soustraction, premiers moyens 14 de multiplication ; il peut même être quasi-nul si les éléments fonctionnent quasi-instantanément. Cette remarque vaut aussi pour le deuxième registre 12 et l'échantillon de signal $W_{n-2}$.

Par ailleurs le générateur numérique de fréquences F comporte de préférence des deuxièmes moyens 15 de soustraction, des deuxièmes moyens 16 de multiplication ayant un coefficient de multiplication valant $\cos(\theta)$, des troisièmes moyens 17 de multiplication ayant un coefficient de multiplication valant $\sin(\theta)$. L'entrée directe + des deuxièmes moyens 15 de soustraction est reliée à la sortie $\Delta$ des premiers moyens 13 de soustraction. L'entrée inverseuse - des deuxièmes moyens 15 de soustraction est reliée à la sortie des deuxièmes moyens 16 de multiplication dont l'entrée est reliée à la sortie S du premier registre 11 à laquelle est aussi reliée l'entrée des troisièmes moyens 17 de multiplication. La ou les sorties du générateur peuvent se situer au niveau de l'entrée E ou de la sortie S de l'un et/ou l'autre des registres 11 et 12. Par exemple, si une sortie du générateur se trouve au niveau de la sortie S du premier registre 11, l'échantillon de signal de sortie vaudra $W_{n-1}$. Dans le mode de réalisation correspondant à la figure 1, le générateur comporte de préférence deux sorties Q et I qui sont avantageusement reliées respectivement au niveau de la sortie $\Delta$ des premiers moyens 13 de soustraction et au niveau de la sortie des troisièmes moyens 17 de multiplication.

Les différents échantillons de signal $W_n$, $W_{n-1}$, $W_{n-2}$, sont définis par récurrence, la relation de récurrence valant $W_n = 2\cos(\theta)W_{n-1} - W_{n-2}$, n étant un entier représentant le p$^{ième}$ coup d'horloge, p pouvant être différent de n, cela dépendant des valeurs initiales. Les échantillons de signal chargés sur les entrées EC de chargement des registres jouent le rôle de valeurs initiales pour la relation de récurrence. La série des $W_n$ dépend des valeurs initiales chargées sur les deuxièmes entrées EC de chargement des registres 11 et 12. Supposons que soient chargés sur ces deuxièmes entrées EC de chargement des registres 11 et 12, des échantillons de signal valant respectivement $\sin((n-1)\theta)$ et $\sin((n-2)\theta)$, c'est-à-dire correspondant aux valeurs d'un signal de fréquence F aux $n-1^{ième}$ et $n-2^{ième}$ instants d'échantillonnage, avec $\theta=2\pi FT_{ech}$, $T_{ech}$ étant la période d'échantillonnage. Au coup d'horloge suivant, $W_{n-1}$ et $W_{n-2}$ valent respectivement $\sin((n-1)\theta)$ et $\sin((n-2)\theta)$ ; $W_n$ est alors donné par la relation de récurrence précédente et vaut alors $\sin(n\theta)$, c'est-à-dire la valeur du signal de fréquence F précédent, au $n^{ième}$ instant d'échantillonnage ; et ainsi de suite pour le $n+1^{ième}$ et tous les autres instants d'échantillonnage suivants: on génère ainsi un signal numérique de fréquence F ayant une période d'échantillonnage $T_{ech}$. Pour changer de fréquence porteuse F ou bien pour changer de fréquence d'échantillonnage $F_{ech}=1/T_{ech}$, il suffit de charger de nouveaux échantillons de signal de valeur adéquate sur les entrées EC de chargement des registres 11 et 12. Des exemples préférentiels seront examinés ultérieurement.

Les échantillons de signal de sortie, c'est-à-dire disponibles sur les sorties I et Q, valent respectivement $\sin(\theta) \cdot W_{n-1}$ et $W_n - \cos(\theta) \cdot W_{n-1}$. De préférence, les échantillons de signal chargés lors de l'initialisation du générateur sont de la forme $\frac{\sin((n-1)\theta}{\sin\theta}$ et $\frac{\sin((n-2)\theta)}{\sin\theta}$, ce qui donne au niveau des sorties I et Q des échantillons de signal valant respectivement $\sin((n-1)\theta)$ et $\cos((n-1)\theta)$, c'est-à-dire des signaux de sortie qui sont en quadrature de phase. Le générateur est alors avantageusement utilisé dans un dispositif de modulation et/ou de démodulation quadratique, qu'on trouve par exemple dans les systèmes radar. Les moyens de multiplication et de soustraction ainsi que les registres utilisés pour générer les valeurs $W_n$ sont communs pour les voies I et Q, ce qui permet d'avoir des bruits corrélés et d'éviter ainsi l'apparition d'une raie BLU.

Un exemple d'application est la vobulation de fréquence de récurrence pour des raisons de robustesse au brouillage. Dans une application radar, le nombre de cases distances est égal au rapport de la fréquence d'échantillonnage sur la fréquence de récurrence, et ce nombre doit rester constant de préférence. Donc lorsque la fréquence de récurrence varie, la fréquence d'échantillonnage doit varier dans les mêmes proportions. Soit F la fréquence porteuse et $T_0$ et $T_1$ deux périodes d'échantillonnage correspondant à deux fréquences d'échantillonnage différentes. En fait, la vobulation de fréquence de récurrence se traduit par un changement de période d'échantillonnage. Or, un changement de période d'échantillonnage se traduit par un saut de phase $\Delta\varphi$ qui est gênant lorsqu'il n'est pas maîtrisé: le générateur selon l'invention permet de maîtriser ce saut de phase. En effet, examinons, dans le cas où les échantillons valent $W_n = \sin(n\theta)$, ce qui se passe lors d'un changement de période d'échantillonnage, lors du passage de la période $T_0$ à la période $T_1$ par exemple. Soient $t_0$ et $t_1$ des instants, K un entier, $\phi_0$ une phase donnée quelconque, on a alors :

$$\text{à } t_0 \qquad \text{la génération de } W_n = \sin(2\pi FnT_0 + \phi_0)$$

$$\text{à } t_0 + T_0 \qquad \text{la génération de } W_{n+1} = \sin(2\pi F(n+1)T_0 + \phi_0)$$
$$\text{à } t_0 + 2T_0 \qquad \text{la génération de } W_{n+2} = \sin(2\pi F(n+2)T_0 + \phi_0)$$

$$\text{.............} \qquad \text{.................................................................}$$
$$\text{à } t_0 + (K-1)T_0 \qquad \text{la génération de } W_{n+K-1} = \sin(2\pi F(n+(K-1))T_0 + \phi_0)$$
$$\text{à } t_1 = t_0 + KT_0, \text{ on passe de la période } T_0 \text{ à la période } T_1, \text{ et on obtient alors}$$
$$\text{la génération de } W_{n+K} = \sin(2\pi F(n+K)T_1 + \phi_0)$$
$$\text{à } t_1 + T_1 \qquad \text{la génération de } W_{n+K+1} = \sin(2\pi F(n+K+1)T_1 + \phi_0)$$

Or, à l'instant $t_1$, comme $(n+K)T_1 \neq (n+K)T_0$, le saut de phase $\Delta\varphi$ effectué vaut : $\Delta\varphi = 2\pi F(n+K)(T_1-T_0)$.

Pour compenser ce saut de phase, il suffit de remplacer au niveau d'une deuxième entrée EC de chargement d'un registre la phase $\phi_0$ par une nouvelle phase $\phi_1$ qui vaut : $\phi_1 = \phi_0 - \Delta\varphi = \phi_0 - 2\pi F(n+K)(T_1-T_0)$, ce qui est effectué en chargeant, sur cette entrée EC de chargement, la valeur $W_{n+K}=\sin(2\pi F(n+K)T_1+\phi_1)$. Une correction analogue, la valeur de n seul étant changée, est appliquée au deuxième registre. Le changement de période et donc de fréquence d'échantillonnage peut alors être effectué avec une grande précision ne dépendant que du nombre de bits des registres et des moyens de soustraction et de multiplication, c'est-à-dire de la dynamique existante au niveau du générateur. Le saut de phase peut être corrigé avec la même précision. La précision de la maîtrise de la phase dans un générateur selon l'invention n'est donc limitée que par la dynamique de ce même générateur. Le nombre de bits étant limité, lors des calculs il apparaît des erreurs de troncature. En plus d'une grande stabilité intrinsèque du générateur, le fait que les registres soient chargés au niveau de leur deuxième entrée EC de chargement assez souvent, typiquement toutes les quelques secondes, élimine toute possibilité de divergence du générateur à cause de ces erreurs de troncature.

Un autre exemple d'application est le mode multifréquence, c'est-à-dire l'utilisation successive de plusieurs fréquences porteuses, afin de diminuer l'ambiguïté distance d'un radar par exemple. Pour la simplicité de la présentation, on considère un mode bifréquence, c'est-à-dire avec une fréquence porteuse qui alterne entre deux valeurs $F_1$ et $F_2$. Si par exemple les fréquences porteuses sont utilisées pendant des périodes identiques, en alternance impulsion à impulsion, la distance d'ambiguïté est approximativement doublée. Ici, on ne se préoccupe pas du saut de phase lors du changement de fréquence, mais on tient à conserver pour chaque fréquence porteuse une phase constante, c'est-à-dire que les fréquences porteuses $F_1$ et $F_2$ doivent conserver des phases constantes $\phi_1$ et $\phi_2$. Cette constance de phase est importante pour l'exploitation de l'effet Doppler. En raisonnant de manière similaire à celle du premier exemple de vobulation, on constate qu'il suffit de compenser au niveau de la deuxième entrée EC de chargement du registre un saut de phase $\Delta\phi_{1->2}$ lors du passage de $F_1$ à $F_2$, et un saut de phase $\Delta\phi_{2->1}$ lors du passage de $F_2$ à $F_1$. Soient $N_1$ et $N_2$ les nombres d'échantillons générés respectivement avec les fréquences $F_1$ et $F_2$, soit T la période d'échantillonnage, on a : $\Delta\phi_{1->2} = 2\pi F_1 N_1 T$ et $\Delta\phi_{2->1} = 2\pi F_2 N_2 T$. Ici également, les phases associées aux fréquences porteuses sont maîtrisées avec une précision qui n'est limitée que par la dynamique du générateur.

Dans les deux exemples précédents, la vobulation de fréquence de récurrence et le mode multifréquences porteuses, un avantage supplémentaire est l'absence de période transitoire. En effet, le chargement numérique des registres au niveau de leur deuxième entrée EC de chargement permet de compenser instantanément les sauts de phase. Dans les deux exemples précédents, la maîtrise de la phase consistait en une conservation de phase ; il est clair que l'invention, permettant une maîtrise complète de la phase, autorise par conséquent bien d'autres manipulations de la phase que sa simple conservation.

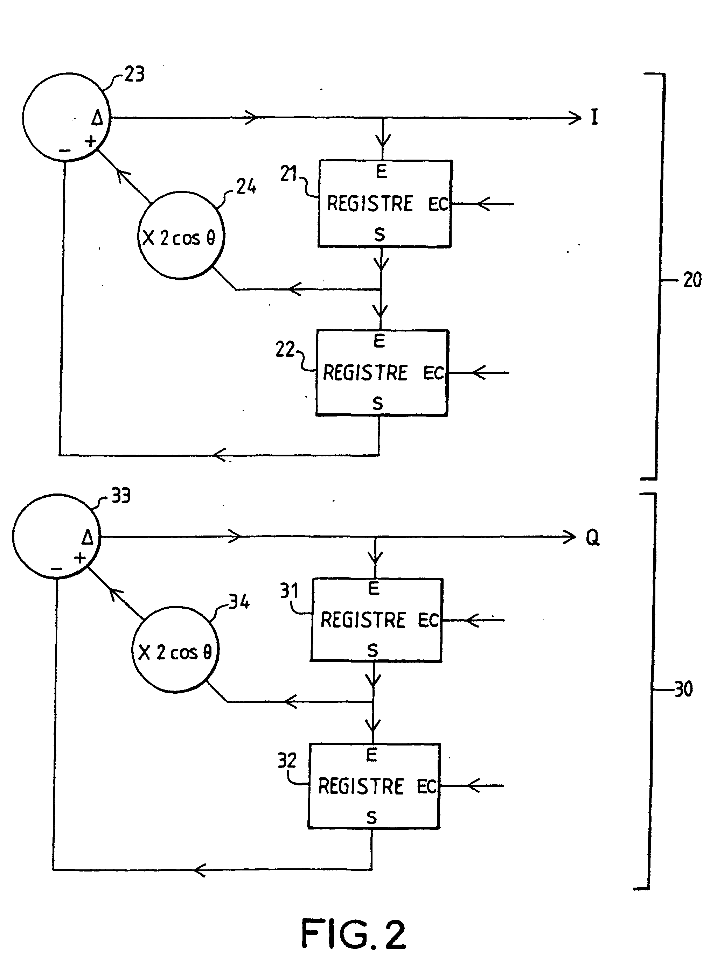

La figure 2 représente schématiquement un deuxième mode de réalisation d'un générateur numérique selon l'invention. Sauf mention contraire, les éléments sont reliés entre eux comme sur la figure 1. Le générateur comporte deux réseaux 20 et 30 récursifs du deuxième ordre identiques au réseau 10 de la figure 1. Les éléments 21 à 24, ainsi que les éléments 31 à 34, sont respectivement identiques aux éléments 11 à 14 de la figure 1. Soit I et Q les sorties du générateur, I et Q sont avantageusement respectivement reliées aux sorties A des premiers moyens 23 et 33 de soustraction. I et Q pourraient également être respectivement reliées aux sorties S des premiers registres 21 et 31 ou bien à celles des deuxièmes registres 22 et 32. De préférence, lors de l'initialisation du générateur, ou bien lors d'un changement de fréquence porteuse ou de fréquence de récurrence, les échantillons de signal chargés au niveau des deuxièmes entrées EC de chargement des registres 21 et 31 sont en quadrature de phase, les échantillons de signal chargés au niveau des deuxièmes entrées EC de chargement des registres 22 et 32 aussi. De cette manière, les signaux disponibles sur les sorties I et Q du générateur seront en quadrature de phase. En présentant moins de moyens de multiplication que le mode de réalisation de la figure 1, les moyens 24 et 34 au lieu des moyens 14, 16 et 17, le mode de réalisation de la figure 2 est moins lourd à réaliser.

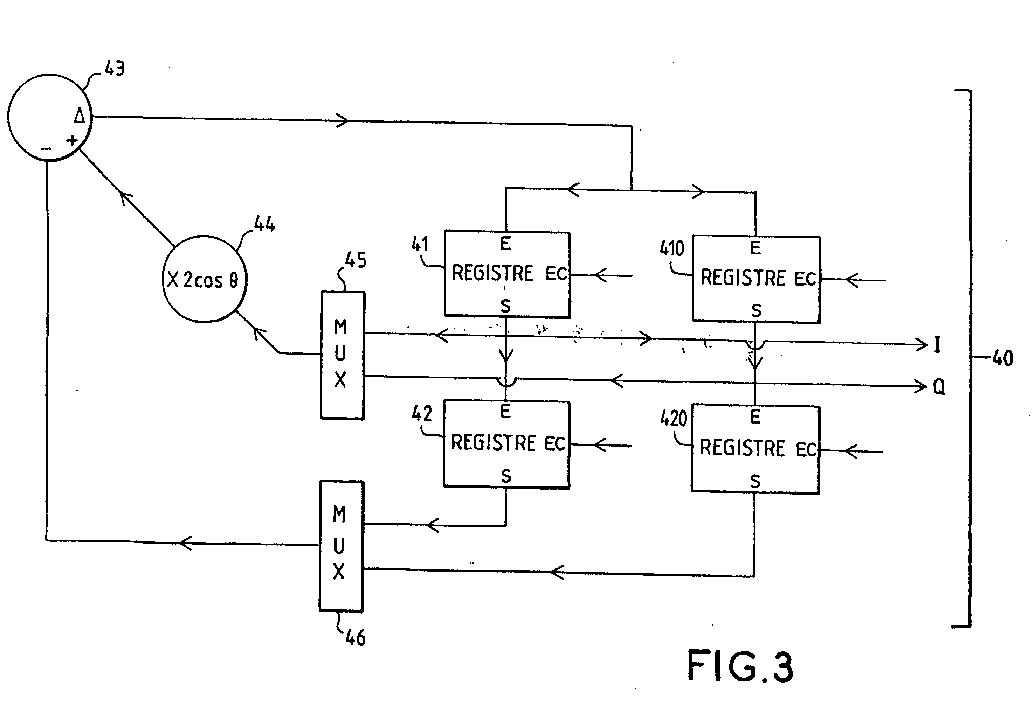

La figure 3 représente schématiquement un troisième mode de réalisation d'un générateur numérique selon l'invention. Sauf mention contraire, les éléments sont reliés entre eux comme sur la figure 1. Le générateur comporte un réseau 40 récursif du deuxième ordre différent de ceux des figures précédentes. Les éléments 43 et 44 sont identiques aux éléments 23 et 24 de la figure 2. Les registres 41 et 410 sont identiques aux registres 21 et 31 de la figure 2 et les registres 42 et 420 sont identiques aux registres 22 et 32 de la figure 2. Les registres sont répartis en deux groupes, le premier groupe comportant les registres 41 et 42 en série, le deuxième groupe comportant les registres 410 et 420 en série. Les entrées E des registres 41 et 410 sont reliées à la sortie Δ des moyens 43 de soustraction. Les sorties I et Q du générateur sont avantageusement respectivement reliées aux sorties S des registres 41 et 410, mais elles pourraient aussi être respectivement reliées aux sorties S des registres 42 et 420. Le réseau 40 comporte des multiplexeurs 45 et 46, symbolisés MUX sur la figure. Le multiplexeur 45 a deux entrées qui sont reliées respectivement aux sorties S des registres 41 et 410, et a une sortie à laquelle est reliée l'entrée des moyens 44 de multiplication. Le multiplexeur 46 a deux entrées qui sont reliées respectivement aux sorties S des registres 42 et 420, et a une sortie à laquelle est reliée l'entrée inverseuse - des moyens 43 de soustraction. Les multiplexeurs 45 et 46 permettent de commuter alternativement le premier et le deuxième groupe de registres.

De préférence, lors de l'initialisation du générateur, ou bien lors d'un changement de fréquence porteuse ou de fréquence de récurrence, les échantillons de signal chargés au niveau des deuxièmes entrées EC de chargement des registres 41 et 410 sont en quadrature de phase, les échantillons de signal chargés au niveau des deuxièmes entrées EC de chargement des registres 42 et 420 aussi. De cette manière, les signaux disponibles sur les sorties I et Q du générateur seront en quadrature de phase.

Dans tous les modes de réalisation précédents, le générateur selon l'invention peut être appliqué à tout domaine de fréquences, il s'agit pour cela de choisir des composants adaptés au domaine de fréquences en question.

**Revendications**

1. Générateur numérique de fréquences F ayant une horloge avec une période d'échantillonnage $T_{ech}$ et comportant un premier réseau (10, 20, 40) récursif du deuxième ordre, le premier réseau (10, 20, 40) comportant :

   - un premier groupe de deux registres (11 et 12, 21 et 22, 41 et 42) à décalage en série pouvant chacun stocker un échantillon de signal et comportant chacun une première entrée (E), une deuxième entrée (EC) de chargement, une sortie (S) ;
   - des premiers moyens (14, 24, 44) de multiplication comportant une entrée et une sortie et ayant un coefficient de multiplication valant 2cos($\theta$) avec $\theta$ valant $2\pi FT_{ech}$ ;
   - des premiers moyens (13, 23, 43) de soustraction comportant une entrée directe (+), une entrée inverseuse (-), une sortie ($\Delta$);

   la sortie (S) du premier registre (11, 21, 41) étant reliée à la première entrée (E) du deuxième registre (12, 22, 42), la première entrée (E) du premier registre (11, 21, 41) étant reliée à la sortie ($\Delta$) des premiers moyens (13, 23, 43) de soustraction, la sortie (S) du deuxième registre (12, 22, 42) étant reliée à l'entrée inverseuse (-) des premiers moyens (13, 23, 43) de soustraction, l'entrée des premiers moyens (14, 24, 44) de multiplication étant reliée à la sortie (S) du premier registre (11, 21, 41), la sortie des premiers moyens (14, 24, 44) de multiplication étant reliée à l'entrée directe (+) des premiers moyens (13, 23, 43) de soustraction, les deuxièmes entrées (EC) de chargement des premier et deuxième registres (11 et 12, 21 et 22, 41 et 42) étant reliées à l'extérieur ;
   à chaque coup d'horloge, l'échantillon de signal stocké dans chaque registre (11, 12, 21, 22, 41, 42) étant rendu disponible sur sa sortie (S), les premiers moyens (14, 24, 44) de multiplication effectuant une opération de multiplication, les premiers moyens (13, 23, 43) de soustraction effectuant une opération de soustraction, l'échantillon de signal reçu à l'entrée (E) de chaque registre (11, 12, 21, 22, 41, 42) étant stocké dans ledit registre (11, 12, 21, 22, 41, 42) ;
   **caractérisé en ce que** le générateur comporte des moyens de commande des registres remplaçant, lors d'un changement de fréquence porteuse F ou bien lors d'un changement de période d'échantillonnage $T_{ech}$, l'échantillon de signal stocké dans chaque registre (11, 12, 21, 22, 41, 42) par un échantillon de signal chargé à partir de l'extérieur au niveau de sa deuxième entrée (EC) de chargement et déterminé de manière à maîtriser la phase de la fréquence F.

2. Générateur selon la revendication 1, **caractérisé en ce que** le générateur comporte aussi des deuxièmes moyens (15) de soustraction, des deuxièmes moyens (16) de multiplication ayant un coefficient de multiplication valant cos($\theta$), des troisièmes moyens (17) de multiplication ayant un coefficient de multiplication valant sin($\theta$) ; l'entrée directe (+) des deuxièmes moyens (15) de soustraction étant reliée à la sortie ($\Delta$) des premiers moyens (13) de soustraction, les entrées des deuxièmes (16) et troisièmes (17) moyens de multiplication étant reliées à la sortie (S) du premier registre (11), la sortie des deuxièmes moyens (16) de multiplication étant reliée à l'entrée inverseuse (-) des deuxièmes moyens (15) de soustraction, les sorties (I, Q) du générateur étant reliées aux sorties des deuxièmes moyens (15) de soustraction et des troisièmes moyens (17) de multiplication.

3. Générateur selon la revendication 1, **caractérisé en ce que** le générateur comporte un deuxième réseau (30) récursif identique au premier réseau (20), les registres (21, 22, 31, 32) étant chargés initialement par leur entrée (EC) de chargement avec des échantillons de signal en quadrature de phase entre les deux réseaux (20, 30), registre à registre, les sorties (I, Q) du générateur étant reliées aux sorties ($\Delta$) des premiers moyens (23, 33) de soustraction ou aux sorties (S) des premiers registres (21, 31) ou aux sorties (S) des deuxièmes registres (22, 32).

4. Générateur selon la revendication 1, **caractérisé en ce que** le réseau (40) comporte en parallèle du premier groupe un deuxième groupe de deux registres (410, 420) à décalage en série, les sorties (S) des premiers registres (41, 410) étant reliées à l'entrée des premiers moyens de multiplication (44) par l'intermédiaire d'un premier multiplexeur (45), les sorties (I, Q) du générateur étant reliées aux sorties (S) des premiers registres (41, 410) ou aux sorties (S) des deuxièmes registres (42, 420), les sorties (S) des deuxièmes registres (42, 420) étant reliées à l'entrée inverseuse (-) des premiers moyens (43) de soustraction par l'intermédiaire d'un deuxième multiplexeur (46), et les registres (41, 42, 410, 420) étant chargés initialement par leur entrée (EC) de chargement avec des échantillons de signal en quadrature de phase entre les deux groupes, registre à registre, et **en ce qu'**à chaque coup d'horloge, chacun des deux groupes alternativement est sélectionné par les deux multiplexeurs (45 et 46) simultanément.

5. Générateur selon l'une quelconque des revendications 1 à 4, **caractérisé en ce que** le générateur est utilisé dans un dispositif de modulation et/ou de démodulation quadratique.

6. Générateur selon l'une quelconque des revendications 1 à 5, **caractérisé en ce que** des échantillons de signal sont chargés à partir de l'extérieur au niveau des deuxièmes entrées (EC) de chargement des registres (11, 12, 21, 22, 31, 32, 41, 410, 42, 420) de manière à faire de la vobulation de fréquence de récurrence à phase constante.

7. Générateur selon l'une quelconque des revendications 1 à 5, **caractérisé en ce que** des échantillons de signal sont chargés à partir de l'extérieur au niveau des deuxièmes entrées (EC) de chargement des registres (11, 12, 21, 22, 31, 32, 41, 410, 42, 420) de manière à ce que le générateur fonctionne en mode multifréquence, chaque fréquence porteuse conservant une phase constante.

**Patentansprüche**

1. Digitaler Generator für Frequenzen F mit einem Taktgeber für eine Tastperiode $T_{ech}$ und mit einem ersten rekursiven Netz (10, 20, 40) der zweiten Ordnung, wobei das erste Netz (10, 20, 40) enthält:

   - eine erste Gruppe von zwei Schieberegistern (11, 12; 21, 22; 41, 42) in Reihe, die je eine Signaltastprobe speichern können und je einen ersten Eingang (E), einen zweiten Eingang. (EC) als Lade-Eingang und einen Ausgang (S) besitzen,
   - erste Multiplikationmsmittel (14, 24, 44) mit einem Eingang und einem Ausgang sowie einem Multiplikationsfaktor des Werts 2.cosè, wobei gilt è = $2\pi FT_{ech}$,
   - erste Subtraktionsmittel (13, 23, 43) mit einem direkten Eingang ("+") und einem inversen Eingang ("-") sowie einem Ausgang (Ä),

   wobei der Ausgang (S) des ersten Registers (11, 21, 41) an den ersten Eingang (E) des zweiten Registers (12, 22, 42), der erste Eingang (E) des ersten Registers (11, 21, 41) an den Ausgang (Ä) der ersten Subtraktionsmittel (13, 23, 43), der Ausgang (S) des zweiten Registers (12, 22, 42) an den inversen Eingang ("-") der ersten Subtraktionsmittel (13, 23, 43), der Eingang der ersten Multiplikationsmittel (14, 24, 44) an den Ausgang (S) des ersten Registers (11, 21, 41) und der Ausgang der ersten Multiplikationsmittel (14, 24, 44) an den direkten Eingang ("+") der ersten Subtraktionsmittel (13, 23, 43) angeschlossen sind und die Lade-Eingänge (EC) des ersten und des zweiten Registers (11, 12; 21, 22; 41, 42) von außen gespeist werden, und wobei in jedem Takt die in jedem Register (11, 12, 21, 22, 41, 42) gespeicherte Signaltastprobe an dessen Ausgang (S) verfügbar wird und die ersten Multiplikationsmittel (14, 24, 44) eine Multiplikationsoperation und die ersten Subtraktionsmittel (13, 23, 43) eine Subtraktionsoperation durchführen und wobei die am Eingang (E) jedes Registers (11, 12, 21, 22, 41, 42) empfangene Signaltastprobe im Register (11, 12, 21, 22, 41, 42) gespeichert wird, **dadurch gekennzeichnet, daß** der Generator Steuermittel für die Register enthält, die beim Laden einer Trägerfrequenz F oder auch beim Wechsel der Tastperiode $T_{ech}$ die in jedem Register (11, 12, 21, 22, 41, 42) gespeicherte Signaltastprobe durch eine Signaltastprobe ersetzt, die über den Lade-Eingang (EC) geladen wurde und so bestimmt ist, daß die Phase der Frequenz F beherrscht wird.

2. Generator nach Anspruch 1, **dadurch gekennzeichnet, daß** er auch zweite Subtraktionsmittel (15), zweite Multiplikationsmittel (16) mit einem Multiplikationsfaktor cosè, und dritte Multiplikationsmittel (17) mit einem Multiplikationsfaktor sine besitzt, wobei der direkte Eingang ("+") der zweiten Subtraktionsmittel (15) an den Ausgang (Ä) der ersten Subtraktionsmittel (13), die Eingänge der zweiten Multiplikationsmittel (16) und der dritten Multiplikationsmittel (17) an den Ausgang (S) des ersten Registers (11), der Ausgang der zweiten Multiplikationsmittel (16) an den inversen Eingang ("-") der zweiten Subtraktionsmittel (15) und die Ausgänge (Q, I) des Generators an die Ausgänge der zweiten Subtraktionsmittel (15) beziehungsweise der dritten Multiplikationsmittel (17) angeschlossen sind.

3. Generator nach Anspruch 1, **dadurch gekennzeichnet, daß** er ein zweites rekursives Netz (30) gleich dem ersten rekursiven Netz (20) enthält, wobei die Register (21, 22, 31, 32) ursprünglich über ihren Lade-Eingang (EC) mit Signaltastproben in Phasenquadratur zwischen den beiden Netzen, Register für Register, geladen werden und wobei die Ausgänge (I, Q) des Generators an die Ausgänge (?) der ersten Subtraktionsmittel (23, 33) oder an die Ausgänge (S) der ersten Register (21, 31) oder an die Ausgänge (S) der zweiten Register (22, 32) angeschlossen sind.

**4.** Generator nach Anspruch 1, **dadurch gekennzeichnet, daß** das Netz (40) parallel zur ersten Gruppe eine zweite Gruppe von zwei Schieberegistern (410, 420) in Reihe enthält, wobei die Ausgänge (S) der ersten Register (41, 410) an den Eingang der ersten Multiplikationsmittel (44) über einen ersten Multiplexer (45) und die Ausgänge (I, Q) des Generators an die Ausgänge (S) der ersten Register (41, 410) oder an die Ausgänge (S) der zweiten Register (42, 420) angeschlossen sind, während die Ausgänge (S) der zweiten Register (42, 420) an den inversen Eingang ("-") der ersten Subtraktionsmittel (43) über einen zweiten Multiplexer (46) angeschlossen sind, wobei die Register (41, 42, 410, 420) ursprünglich über ihren Lade-Eingang (EC) mit Signaltastproben in Phasenquaratur zwischen den beiden Gruppen, Register für Register, geladen werden, und daß bei jedem Takt die beiden Gruppen simultan und abwechselnd von den beiden Multiplexern (45, 46) ausgewählt werden.

**5.** Generator nach einem beliebigen der Ansprüche 1 bis 4, **dadurch gekennzeichnet, daß** er in einer Vorrichtung zur quadratischen Modulation und/oder Demodulation verwendet wird.

**6.** Generator nach einem beliebigen der Ansprüche 1 bis 5, **dadurch gekennzeichnet, daß** Signaltastproben von außen an die Lade-Eingänge (EC) der Register (11, 12, 21, 22, 41, 410, 42, 420) derart geliefert werden, daß sich eine Wobbelung der Rekurrenzfrequenz mit konstanter Phase ergibt.

**7.** Generator nach einem beliebigen der Ansprüche 1 bis 5, **dadurch gekennzeichnet, daß** Signaltastproben von außen an die Lade-Eingänge (EC) der Register (11, 12, 21, 22, 31, 32, 41, 410, 42, 420) derart geliefert werden, daß der Generator im Mehrfrequenzmodus arbeitet und jede Frequenz ihre Phase konstant beibehält.

**Claims**

**1.** Digital generator of frequencies F having a clock with a sampling period $T_{ech}$ and comprising a first second-order recursive network (10, 20, 40), the first network (10, 20, 40) comprising:

- a first group of two shift registers (11 and 12, 21 and 22, 41 and 42) in series, each able to store a signal sample and each comprising a first input (E), a second loading input (EC), an output (S);
- first means (14, 24, 44) of multiplication comprising an input and an output and having a multiplication coefficient equalling $2\cos(\theta)$ with $\theta$ equalling $2\pi FT_{ech}$;
- first means (13, 23, 43) of subtraction comprising a direct input (+), an inverting input (-), an output (Δ);

the output (S) of the first register (11, 21, 41) being linked to the first input (E) of the second register (12, 22, 42), the first input (E) of the first register (11, 21, 41) being linked to the output (Δ) of the first means (13, 23, 43) of subtraction, the output (S) of the second register (12, 22, 42) being linked to the inverting input (-) of the first means (13, 23, 43) of subtraction, the input of the first means (14, 24, 44) of multiplication being linked to the output (S) of the first register (11, 21, 41), the output of the first means (14, 24, 44) of multiplication being linked to the direct input (+) of the first means (13, 23, 43) of subtraction, the second loading inputs (EC) of the first and second registers (11 and 12, 21 and 22, 41 and 42) being linked to the outside; with each clock tick, the signal sample stored in each register (11, 12, 21, 22, 41, 42) being rendered available on its output (S), the first means (14, 24, 44) of multiplication performing a multiplication operation, the first means (13, 23, 43) of subtraction performing a subtraction operation, the signal sample received at the input (E) of each register (11, 12, 21, 22, 41, 42) being stored in the said register (11, 12, 21, 22, 41, 42); **characterized in that** the generator comprises means of control of the registers replacing, upon a change of carrier frequency F or else upon a change of sampling period $T_{ech}$, the signal sample stored in each register (11, 12, 21, 22, 41, 42) by a signal sample loaded from outside at the level of its second loading input (EC) and determined in such a way as to control the phase of the frequency F.

**2.** Generator according to Claim 1, **characterized in that** the generator also comprises second means (15) of subtraction, second means (16) of multiplication having a multiplication coefficient equalling $\cos(\theta)$, third means (17) of multiplication having a multiplication coefficient equalling $\sin(\theta)$; the direct input (+) of the second means (15) of subtraction being linked to the output (Δ) of the first means (13) of subtraction, the inputs of the second (16) and third (17) means of multiplication being linked to the output (S) of the first register (11), the output of the second means (16) of multiplication being linked to the inverting input (-) of the second means (15) of subtraction, the outputs (I, Q) of the generator being linked to the outputs of the second means (15) of subtraction and of the third means (17) of multiplication.

3. Generator according to Claim 1, **characterized in that** the generator comprises a second recursive network (30) identical to the first network (20), the registers (21, 22, 31, 32) being loaded initially via their loading input (EC) with signal samples in phase quadrature between the two networks (20, 30), register by register, the outputs (I, Q) of the generator being linked to the outputs (Δ) of the first means (23, 33) of subtraction or to the outputs (S) of the first registers (21, 31) or to the outputs (S) of the second registers (22, 32).

4. Generator according to Claim 1, **characterized in that** the network (40) comprises in parallel with the first group a second group of two shift registers (410, 420) in series, the outputs (S) of the first registers (41, 410), being linked to the input (E) of the first means of multiplication (44) by way of a first multiplexer (45), the outputs (I, Q) of the generator being linked to the outputs (S) of the first registers (41, 410) or to the outputs (S) of the second registers (42, 420), the outputs (S) of the second registers (42, 420) being linked to the inverting input (-) of the first means (43) of subtraction by way of a second multiplexer (46), and the registers (41, 42, 410, 420) being loaded initially via their loading input (EC) with signal samples in phase quadrature between the two groups, register by register, and **in that** with each clock tick, each of the two groups alternately is selected by the two multiplexers (45 and 46) simultaneously.

5. Generator according to any one of Claims 1 to 4, **characterized in that** the generator is used in a quadratic modulation and/or demodulation device.

6. Generator according to any one of Claims 1 to 5, **characterized in that** signal samples are loaded from outside at the level of the second loading inputs (EC) of the registers (11, 12, 21, 22, 31, 32, 41, 410, 42, 420) in such a way as to effect recurrence frequency wobbulation at constant phase.

7. Generator according to any one of Claims 1 to 5, **characterized in that** signal samples are loaded from outside at the level of the second loading inputs (EC) of the registers (11, 12, 21, 22, 31, 32, 41, 410, 42, 420) in such a way that the generator operates in multifrequency mode, each carrier frequency keeping a constant phase.

FIG.1

FIG.2

FIG.3

EP 0 989 669 B1